(19) Europäisches Patentamt
European Patent Office
Office européen des brevets

(11) **EP 3 506 507 A1**

(12) **EUROPEAN PATENT APPLICATION**

(43) Date of publication:
**03.07.2019 Bulletin 2019/27**

(51) Int Cl.:
**H03K 17/16** (2006.01)

(21) Application number: **17382908.6**

(22) Date of filing: **27.12.2017**

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**
Designated Extension States:
**BA ME**
Designated Validation States:
**MA MD TN**

(71) Applicant: **Ikerlan, S. Coop.
20500 Mondragon (ES)**

(72) Inventors:
• **GARCIA BEDIAGA, Asier
48200 DURANGO (ES)**
• **MIR FAGOAGA, Luis
20500 ARRASATE - MONDRAGON (ES)**
• **RUJAS DIEZ, Alejandro
01002 VITORIA - GASTEIZ (ES)**

(74) Representative: **Igartua, Ismael et al
Galbaian S. Coop.
Garaia Parke Teknologikoa
Goiru Kalea 1
20500 Arrasate-Mondragón (ES)**

(54) **GATE DRIVER FOR A SEMICONDUCTOR**

(57) The present invention relates to a gate driver for a semiconductor, which is configured for controlling the switching of the semiconductor (100) by means of control of the injection and extraction of charges in the gate (G) of said semiconductor (100). The driver (200) comprises a sensor (3) adapted for measuring the voltage ($V_{100}$) between the drain (D) and the source (S) of the semiconductor (100), and an actuation unit communicated with the sensor (3) and configured for receiving said voltage ($V_{100}$). The actuation unit is configured for adapting the charge injection or extraction speed in the gate (G) of the semiconductor (100) for switching it, said speed depending on the value of the voltage received from the sensor (3) at the time in which switching is required. The invention also relates to a switching method.

Fig. 2

EP 3 506 507 A1

**Description**

TECHNICAL FIELD

The present invention relates to gate drivers for semiconductors which control the switching of said semiconductors.

PRIOR ART

In the field of power conversion, semiconductors are elements that play an important role. Semiconductors are one of the most important parts of converters, and said converters can have different configurations.

For example, a power converter for converting a DC bus to a DC or AC output can be based on several branches, each of them being made up of two semiconductors arranged in series. Active semiconductors (those requiring a gate driver to open and close them) of one and the same branch can work with both of them being open (no current being conducted through them in the conduction direction) or with one of them being closed and the other one open. Both cannot be closed simultaneously since it would cause a short circuit.

The commands for opening and closing the semiconductors are provided by the control unit of the converter. This control is communicated with the semiconductors by means of gate drivers that are connected to the gate of the semiconductors, such that a control signal reaches the control unit and it converts it into a signal that can open or close the semiconductor. In a safe and controlled manner, each semiconductor can have its own associated gate driver, or each gate driver can control more than one semiconductor (a branch).

On the other hand, due to their features, semiconductors have a maximum voltage limit they can withstand (maximum cut-off voltage or maximum breakdown voltage), and if, because of any situation, the voltage of the DC bus or in terminals of the semiconductor itself (voltage between the drain/collector and source/emitter) exceeds said maximum limit, the semiconductor will be irreparably damaged.

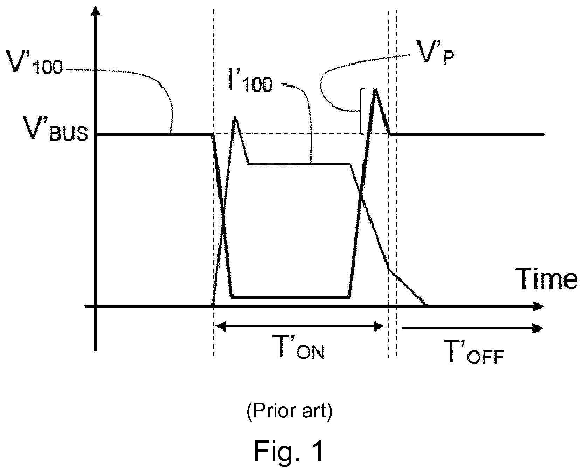

When a semiconductor goes from conducting current (closed) to being completely open, it is a common effect for an overvoltage to be generated in the terminals thereof. This is because there are parasitic inductances in the path that pick up energy as current passes through them (at which time the semiconductor is closed). When the current $I'_{100}$ is suddenly cut off, which is when the semiconductor opens (goes from $T'_{ON}$ to $T'_{OFF}$), the decay slope of the current generates an overvoltage, which adds to the bus voltage. Therefore, the semiconductor ends up with a voltage $V'_{100}$ at its terminals that is equal to the bus voltage $V'_{BUS}$ plus the parasitic voltage $V'_P$ caused by the energy of the parasitic inductance of the circuit, which effect is shown in Figure 1.

Each semiconductor comprises specific features, among which its breakdown voltage can be mentioned, which is the maximum voltage between terminals that can be taken on by the semiconductor without it being irreparably damaged. Therefore, the overvoltage generated in the semiconductor cannot at any time exceed its breakdown voltage, so a semiconductor having a considerable margin between the breakdown voltage and the bus voltage at which it is to work, if said bus voltage is high, is usually selected.

Overvoltage depends on the derivative of current at the opening thereof (decay of current from its conduction value to 0 Amperes). The higher this derivative, the greater the parasitic voltage that is caused for the same value of inductance, as depicted with the following equations:

$$V = L * di/dt,$$

where:

    L: the inductive value of the parasitic inductance;
    di/dt: the rate of decay of the current in the semiconductor; and
    V: generated overvoltage.

However, in contrast, the faster the switching of the semiconductor, and therefore the greater the derivative of current, the lower the losses of energy generated in the semiconductor, so achieving a balance between fast switching to minimize losses or energy lost as heat), and switching that is slow enough so that the overvoltage that is generated does not exceed the breakdown voltage of the semiconductor, is of interest.

It is known that the derivative of current can be controlled by means of the gate driver that controls switching by means of control of the charges that are injected into or extracted from the semiconductor through the gate.

It is known that the charge injection or extraction speed can be controlled by means of a resistor in the gate, so a gate resistor consistent with the needs of the semiconductor is often used. So these needs are identified beforehand and the value of the resistor to be used in the gate is selected.

US20160352321A1, for example, discloses a semiconductor with a resistor connected to its gate. To prevent the effect of overvoltages in the semiconductor, this patent document proposes arranging a diode connected in parallel to the gate resistor. Therefore, when the voltage exceeds a value at the time of closing the semiconductor, said excess is absorbed through the diode.

DISCLOSURE OF THE INVENTION

The object of the invention is to provide a gate driver for a semiconductor and an associated switching method, as defined in the claims.

A first aspect of the invention relates to a gate driver for a semiconductor, which is configured for controlling the injection or extraction of charges in the gate of the semiconductor at the time of switching, and for protecting same. The circuit comprises a voltage sensor adapted for measuring the voltage between the drain/collector and source/emitter of the semiconductor, and an actuation unit communicated with the voltage sensor and configured for receiving and adapting the voltage measured by said voltage sensor. The actuation unit is configured for adapting the charges to be injected or extracted in the gate of the semiconductor in order to close it as a function of the voltage received from the voltage sensor at the time in which the closing of said semiconductor is required.

Therefore, any time the switch has to be opened, the opening speed thereof is controlled, which entails a control of the overvoltage at all times. This enables speeding up the opening the lower the measured voltage is, because there is a larger margin to withstand the overvoltages that are generated during the switching process, losses thereby being minimized, while at the same time preventing the breakdown voltage of the semiconductor from being exceeded due to the overvoltage. Therefore, with the proposed gate driver the switching of the semiconductor can be adapted to each situation to minimize its losses and thereby increase its effectiveness, while at the same time it remains safe without having to oversize it.

This solution is particularly advantageous, but non-limiting, when using semiconductors with very high switching speeds, such as silicon carbide or gallium nitride semiconductors, for example, which have low switching losses among their inherent features. In contrast, said fast switching constitutes a drawback in the overvoltage generated in terminals of the semiconductor, which is duly controlled with the proposed solution.

Furthermore, this solution is particularly advantageous, but non-limiting, in the photovoltaic application, where voltage converters based on semiconductors are used to convert the DC voltage generated by the solar panels to AC voltages for the connection thereof to the power grid. At high bus voltages (solar panel side) the power that must be consumed is low (voltages close to the panel voltages in an open circuit), i.e., little power is requested from the panels and therefore the bus voltage is high. In these circumstances, since not a lot of power is requested, slowing down the switching, and therefore increasing losses, does not have a very significant negative effect on the photovoltaic application. When power starts to be requested from the panels, the bus voltage decays in a natural manner, such that the semiconductor has a lower voltage between terminals and therefore has a larger margin between said voltage and its breakdown voltage, where greater overvoltages may be allowed and where switching may therefore be sped up to minimize losses (which at this time have more of an effect than when the requested power is very low).

A second aspect of the invention relates to a switching method for a semiconductor, wherein the charges to be injected in the gate of said semiconductor are controlled. In the method, the voltage in terminals of the semiconductor, which is the voltage between the drain, or collector, and the source, or emitter, of said semiconductor is measured, and at the time of switching said semiconductor, the charge injection or extraction speed in the gate of the semiconductor is adapted as a function of said voltage in terminals of the semiconductor.

The same advantages as with the first aspect of the invention are thereby obtained.

These and other advantages and features of the invention will become evident in view of the drawings and the detailed description of the invention.

DESCRIPTION OF THE DRAWINGS

Figure 1 shows by means of a graph the effect of the overvoltage on a semiconductor of the state of the art.

Figure 2 schematically shows a first embodiment of the gate driver of the invention, connected to a semiconductor.

Figure 3 schematically shows a second embodiment of the gate driver of the invention, connected to a semiconductor.

DETAILED DISCLOSURE OF THE INVENTION

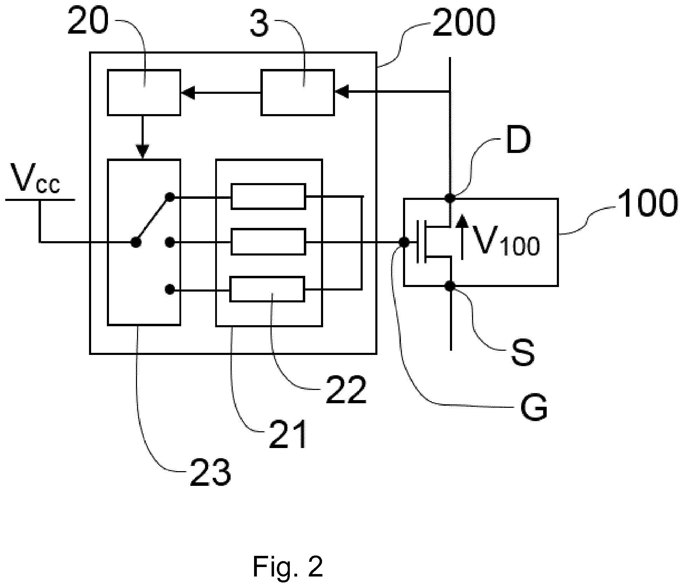

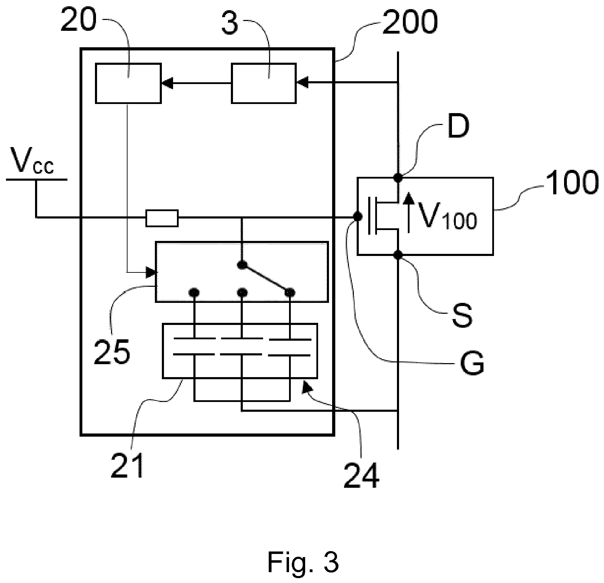

A first aspect of the invention relates to a gate driver 200 which is adapted for causing the switching of at least one semiconductor 100, preferably a single semiconductor 100, preferably of a silicon carbide or gallium nitride (although non-limiting) semiconductor, said circuit 200 therefore being associated with said semiconductor 100, as shown in Figures 2 and 3 by way of example. The gate driver 200 is configured for controlling the switching of the semiconductor 100 by means of control of the injection or extraction of charges in the gate G of said semiconductor 100. When charges are injected, closing of the semiconductor 100 is generated, whereas the opening thereof is caused when charges are extracted.

The gate driver 200 comprises a sensor 3 adapted for measuring the voltage $V_{100}$ in terminals of the semiconductor 100, which is the voltage $V_{100}$ between the drain D (or collector) and the source S (or emitter) of said semiconductor 100. Reference will be made hereinafter to a drain D and source S for the sake of clarity, but they may be a collector and an emitter depending on the semiconductor used. This sensor 3 can be specific for this function, but there are already sensors of this type in some applications where the gate driver 200 is implemented, so it would not be necessary to include additional sensors, and these sensors could furthermore be used for the required function of the gate driver 200.

The gate driver 200 further comprises an actuation unit which is communicated with the sensor 3, thereby receiving the voltage measured by said sensor 3 through a corresponding signal, and is configured for adapting the charge injection or extraction speed in the gate G of the semiconductor 100 for switching it, said amount depending on the value of the voltage received from the sensor 3 at the time when the opening of said semiconductor 100 is required. The switching speed is thereby adjusted to the current work conditions of the semiconductor 100, which on one hand prevents an overvoltage from being generated in the semiconductor 100 that could irreparably damage it, and on the other hand minimizes losses.

The actuation unit is configured for extracting or injecting the charges in the gate G of the semiconductor 100 in a slower manner the higher the voltage $V_{100}$ is in terminals of the semiconductor 100, so as to cause slower switching of the semiconductor 100 and prevent the breakdown voltage of the semiconductor 100 from being exceeded with the generated overvoltage; and for extracting or injecting the charges in the gate G of the semiconductor 100 in a faster manner the lower the voltage $V_{100}$ is in terminals of the semiconductor 100, so as to cause faster switching of the semiconductor 100 (greater overvoltage is allowed since it starts from a voltage $V_{100}$ that is farther away from the breakdown voltage).

The actuation unit comprises a control unit 20 and a variable impedance 21 connected to the gate G of the semiconductor 100. The control unit 20 is communicated with the variable impedance 21 and configured for causing the variation of the value of the impedance 21 as a function of the voltage $V_{100}$ in terminals of the semiconductor 100, when switching of the semiconductor 100 is required, to thereby adjust the charge injection or extraction speed in the gate G as a function of said voltage $V_{100}$ (to adjust the switching speed required of the semiconductor 100, and therefore the generation of overvoltage therein during said switching).

Preferably, the actuation unit further comprises a plurality of stored ratios between the voltage $V_{100}$ in terminals of the semiconductor 100 and the value of the impedance 21, and it is configured for adjusting the value of the impedance 21 as a function of said voltage $V_{100}$ measured at said time and of said previously established ratios. Each value of the impedance 21 can therefore be associated with a value of the voltage $V_{100}$, although each value of the impedance 21 is preferably associated with a range of values of the voltage $V_{100}$. These ratios can be established beforehand, and each semiconductor 100 can have its own ratios because the characteristics may vary among them (within specific tolerances for one and the same type of semiconductors 100).

In a first embodiment shown in Figure 2, the impedance 21 comprises a resistive impedance formed by a plurality of resistors 22, and the gate driver 200 further comprises at least one switch 23 connected in series to the resistive impedance, forming between said switch and said resistive impedance a resistive set which is connected to the gate G at one end and to a power supply $V_{DC}$ at the other end by means of an adapter circuit which is not depicted in the drawings and may be comprised in the gate driver 200 itself. The gate G of the semiconductor 100 is thereby connected to the power supply $V_{DC}$ through the corresponding resistor 22 (or resistors 22) as a function of the switch 23. The power supply $V_{DC}$ powering the gate G of the semiconductor 100 is preferably a supply generated in the gate driver 200, and to close the semiconductor 100 the provided voltage is generally positive, whereas to open it, the provided voltage is generally is negative, with respect to the source S of the semiconductor 100, or nil (depending on the type of semiconductor 100, in general). As a function of the resistor 22 (or resistors 22) through which the gate G is connected to the power supply $V_{DC}$, the charge injection or extraction speed in the gate G will be higher or lower, and therefore the corresponding switching speed of the semiconductor 100 will be higher or lower.

The control unit 20 is communicated with said switch 23 and configured for adjusting its state, i.e., for determining through which resistor 22 (or resistors 22) the gate G is connected to the power supply $V_{DC}$, at least at the time the switching of the semiconductor 100 is required, as a function of the voltage $V_{100}$ measured at that time, for causing the charge injection or extraction speed in the gate G to be the required speed. The resistive impedance is preferably formed by a plurality of resistors 22 connected in parallel, said resistors 22 comprising values of the impedance different from one another. Therefore, there is a plurality of possible gate resistors for the gate G of the semiconductor 100, and the gate resistor 22 required at all times is selected to minimize losses, while at the same time it is assured that, due to the resulting overvoltage, the voltage $V_{100}$ between terminals of the semiconductor 100 does not exceed the breakdown voltage thereof during switching. One of the ends of said resistors 22 are connected to one another and to the gate G of the semiconductor 100 or to the power supply $V_{DC}$, whereas the other ends are not attached to one another and are attached to the switch 23.

In a second embodiment shown in Figure 3, the impedance 21 comprises a capacitive impedance which is formed by a plurality of capacitors 24, and the gate driver 200 further comprises at least one switch 25 connected in series to the capacitive impedance, forming between said switch 25 and said capacitive impedance a capacitive set which is connected between the gate G and the source S (or emitter) of the semiconductor 100. The gate G, and therefore one end of the capacitive set, is connected to a power supply $V_{DC}$ by means of an adapter circuit which is not depicted in the drawings and which may be comprised in the gate driver 200 itself. Everything which has been discussed in relation to the power supply $V_{DC}$ for the first embodiment is also valid for the second embodiment. As a function of the capacitor 24 (or capacitors 24) through which the gate G is connected to the source S, the speed of the charges in the gate G will be higher or lower, and the switching speed of the semiconductor 100 will therefore be higher or lower. The capacitance of the gate G causes a decrease in the voltage dynamics between the gate G and the source S, which means that the semiconductor 100 will need more time for switching, i.e., for the same current in the gate G (same resistance), the current is split between the capacitance of the gate G itself and the capacitance added between said gate G and the source S (capacitors 24).

In the second embodiment, the control unit 20 is communicated with the switch 25 and configured for adjusting its state, at least at the time that switching of the semiconductor 100 is required, as a function of the voltage $V_{100}$ measured at that time, for causing the charge injection or extraction speed in the gate G to be the speed required at that time (for adjusting the required switching speed to the desired value). The capacitive impedance preferably comprises a plurality of capacitors 24 connected in parallel, said capacitors 24 comprising values of the impedance different from one another. Therefore, there is a plurality of possible capacitors 24 for connecting the gate G of the semiconductor 100 with the source S (or emitter), and the capacitor 24 required at all times is selected to minimize losses during switching, while at the same time it is assured that, due to the resulting overvoltage, the voltage $V_{100}$ between terminals of the semiconductor 100 does not exceed the breakdown voltage thereof.

In a third embodiment, not depicted in the drawings, the impedance 21 comprises a resistive impedance like that of the first embodiment, a capacitive impedance like that of the second embodiment, and their respective switches 23 and 25.

A second aspect of the invention relates to a switching method for a semiconductor 100, wherein the charge injection or extraction speed in the gate G of said semiconductor 100 during switching is controlled. The control of the speed is performed in real time and continuously, and to that end the voltage $V_{100}$ in terminals of the semiconductor 100 (voltage between the drain D and source S) is measured, and at the time of switching the semiconductor 100, the charge injection or extraction speed in the gate G thereof is adjusted as a function of the voltage $V_{100}$ measured at that time.

To adjust the charge injection or extraction speed in the gate G of the semiconductor 100 at the time of the switching, the value of an impedance 21 connected to the gate G of said semiconductor 100 is adapted, and this is done such that the charges are extracted or injected in a slower manner in said gate G the higher the voltage is between the drain D and the source S of the semiconductor 100, so as to cause slower switching of the semiconductor 100; and charges are extracted or injected in a faster manner in said gate G the lower the voltage is between the drain D and the source S of the semiconductor 100, so as to cause faster switching of the semiconductor 100, as explained above for the first aspect of the invention.

Preferably, to adjust the value of the impedance 21 in the gate G of the semiconductor 100, the voltage $V_{100}$ measured at that time between the drain D and the source S is compared with previously stored values of the impedance, and the value of the impedance corresponding to said measured voltage $V_{100}$ is established, the value of the impedance 21 being adjusted to said value. That which has been discussed in this respect in the first aspect of the invention is also valid for the method and is therefore not repeated.

In general, that which has been discussed for the gate driver 200 which serves for the switching method also forms part of the second aspect of the invention, even though it has not been explicitly stated in that way above. For example, the method would include acting on switch 23 and/or switch 25, both of which are discussed in the first aspect of the invention.

The method of the invention is adapted for being implemented in a gate driver 200 like the one of the first aspect of the invention, in any of its configurations and/or embodiments. So as a function of the configuration and/or embodiment of the gate driver 200, the method will implement the corresponding configuration and/or embodiment.

Another aspect of the invention relates to a voltage converter comprising a plurality of semiconductors 100, and at least one gate driver 200 according to the first aspect of the invention associated with the semiconductors 100, or a gate driver 200 according to the first aspect of the invention associated with each of the semiconductors 100.

Another aspect of the invention relates to a photovoltaic installation comprising at least one voltage converter comprising a plurality of semiconductors 100, and at least one gate driver 200 according to the first aspect of the invention associated with the semiconductors 100, or a gate driver 200 according to the first aspect of the invention associated with each of the semiconductors 100.

**Claims**

1. Gate driver for a semiconductor, which is configured for controlling the switching of the semiconductor (100) by means of control of the injection or extraction of charges in the gate (G) of said semiconductor (100), **characterised in that** the gate driver (200) comprises a sensor (3) adapted for measuring the

voltage ($V_{100}$) in terminals of the semiconductor (100), which is the voltage between the drain (D), or collector, and the source (S), or emitter, of said semiconductor (100), and an actuation unit communicated with the sensor (3) and configured for receiving the voltage ($V_{100}$) in terminals of the semiconductor (100) and for adapting the charge injection or extraction speed in the gate (G) of the semiconductor (100) for switching it, said speed depending on the value of the voltage ($V_{100}$) in terminals of the semiconductor (100) at the time in which the switching of said semiconductor (100) is required.

2. Gate driver according to claim 1, wherein the actuation unit is configured for causing the charge injection or extraction speed in the gate (G) of the semiconductor (100) to be slower the higher the voltage ($V_{100}$) is in terminals of the semiconductor (100), so as to cause slower switching of the semiconductor (100); and for causing the charge injection or extraction speed in the gate (G) of the semiconductor (100) to be faster the lower the voltage ($V_{100}$) is in terminals of the semiconductor (100), so as to cause faster opening of the semiconductor (100).

3. Gate driver according to claim 2, wherein the actuation unit comprises a control unit (20) and a variable impedance (21) connected to the gate (G) of the semiconductor (100), the control unit (20) being communicated with the variable impedance (21) and configured for causing the variation of the value of the impedance (21) as a function of the voltage ($V_{100}$) in terminals of the semiconductor (100), to adjust the charge injection or extraction speed in the gate (G).

4. Gate driver according to claim 3, wherein the actuation unit further comprises a plurality of stored ratios between the voltage ($V_{100}$) in terminals of the semiconductor (100) and the value of the impedance (21), adjusting the value of the impedance (21) as a function of said voltage ($V_{100}$) and said stored ratios.

5. Gate driver according to claim 3 or 4, wherein the variable impedance (21) comprises a resistive impedance formed by a plurality of resistors (22), the gate driver (200) comprising at least one switch (23) connected in series to the resistive impedance, forming between said switch (23) and said resistive impedance a resistive set which is connected to the gate (G) at one end and to a power supply ($V_{DC}$) at the other end, the gate (G) being connected to the power supply ($V_{DC}$) through at least one of said resistors (22) in a controlled manner as a function of the state of the switch (23), and the control unit (20) being communicated with said switch (23) and configured for adapting the state of said switch (23) as a function of the voltage ($V_{100}$) in terminals of the semiconductor (100).

6. Gate driver according to claim 5, wherein the resistive impedance comprises a plurality of resistors (22) connected in parallel and with different resistive values, one of the ends of said resistors (22) being connected to one another and to the gate (G) or the power supply ($V_{DC}$), and the other end of said resistors (22) being independently connected to the switch (23).

7. Gate driver according to any of the preceding claims, wherein the variable impedance (21) comprises a capacitive impedance formed by a plurality of capacitors (24), the gate driver (200) comprising at least one switch (25) connected in series to the capacitive impedance, forming between said switch (25) and said capacitive impedance a capacitive set that is connected between the gate (G) and the source (S), or emitter, of the semiconductor (100), the gate (G) being connected to the source (S), or emitter, through at least one of said capacitors (24) in a controlled manner as a function of the state of the switch (25), and the control unit (20) being communicated with said switch (25) and configured for adapting the state of said switch (25) as a function of the voltage ($V_{100}$) in terminals of the semiconductor (100).

8. Gate driver according to claim 7, wherein the capacitive impedance comprises a plurality of capacitors (24) connected in parallel and with different capacitive values, one of the ends of said capacitors (24) being connected to one another and to the gate (G) or to the source (S), or emitter, and the other end of said capacitors (24) being connected independently to the switch (25).

9. Gate driver according to any of the preceding claims, wherein the semiconductor (100) is made of silicon, silicon carbide or gallium nitride.

10. Switching method for a semiconductor, wherein the charges to be injected in the gate of said semiconductor (100) are controlled, **characterised in that** the voltage ($V_{100}$) in terminals of the semiconductor (100), which is the voltage between the drain (D), or collector, and the source (S), or emitter, of said semiconductor (100) is measured, and at the time of switching said semiconductor (100), the charge injection or extraction speed in the gate (G) of the semiconductor (100) is adapted as a function of said voltage ($V_{100}$) in terminals of the semiconductor (100).

11. Switching method according to claim 10, wherein to adapt the charge injection or extraction speed in the gate (G) of the semiconductor (100) at the time of switching it, the value of an impedance (21) connected to the gate (G) of said semiconductor (100) is adapted.

**12.** Switching method according to claim 11, wherein the value of the impedance in the gate (G) of the semiconductor (100) is adapted so as to have a slower charge injection or extraction speed in said gate (G) the higher the voltage ($V_{100}$) is in terminals of the semiconductor (100), so as to cause slower switching of the semiconductor (100); and the value of the impedance in the gate (G) of the semiconductor (100) is adapted so as to have a slower charge injection or extraction speed in said gate (G) the lower the voltage ($V_{100}$) is in terminals of the semiconductor (100), so as to cause faster switching of the semiconductor (100).

**13.** Switching method according to claim 11 or 12, wherein to adapt the value of the impedance (21) connected to the gate (G) of the semiconductor (100), the voltage ($V_{100}$) in terminals of the semiconductor (100) at that time is compared with previously stored values of the impedance, the value of the impedance corresponding to said voltage ($V_{100}$) is identified, and the value of the impedance (21) connected to the gate (G) is adjusted to said identified value.

**14.** Voltage converter comprising a plurality of semiconductors (100), **characterised in that** it comprises at least one gate driver (200) according to any of claims 1 to 9 associated with the semiconductors (100), or a gate driver (200) operated according to any of claims 1 to 9 associated with each semiconductor (100).

**15.** Photovoltaic installation, **characterised in that** it comprises at least one converter according to claim 14.

(Prior art)

Fig. 1

Fig. 2

Fig. 3

Europäisches
Patentamt

European
Patent Office

Office européen
des brevets

**EUROPEAN SEARCH REPORT**

Application Number

EP 17 38 2908

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | US 2013/147523 A1 (DEBOY GERALD [AT] ET AL) 13 June 2013 (2013-06-13) | 1-6,9-15 | INV. H03K17/16 |
| Y | * paragraph [0041] - paragraph [0058]; figures 3,5,7,10 * * paragraph [0058] * | 7,8 | |
| Y | US 2013/009671 A1 (SUZUKI YOUICHIROU [JP] ET AL) 10 January 2013 (2013-01-10) | 7,8 | |
| A | * paragraph [0051] - paragraph [0053]; figures 6,10 * | 1-6,9-15 | |
| X | US 2004/196678 A1 (YOSHIMURA KOUSUKE [JP] ET AL) 7 October 2004 (2004-10-07) | 1-6,9-15 | |
| Y | * paragraph [0057] - paragraph [0066]; figures 1,5a,5b,6 * | 7,8 | |
| X | US 2013/155560 A1 (TAKEUCHI TORU [JP]) 20 June 2013 (2013-06-20) | 1-3 | |
| A | * figure 1 * | 4-15 | |
| X | US 2017/272068 A1 (LIANG YUNFENG [SG] ET AL) 21 September 2017 (2017-09-21) | 1-4,9-15 | TECHNICAL FIELDS SEARCHED (IPC) |
| A | * figures 3,6 * | 5-8 | H03K |

The present search report has been drawn up for all claims

| Place of search | Date of completion of the search | Examiner |
|---|---|---|
| The Hague | 1 June 2018 | O'Reilly, Siobhan |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

& : member of the same patent family, corresponding document

EPO FORM 1503 03.82 (P04C01)

## EP 3 506 507 A1

### ANNEX TO THE EUROPEAN SEARCH REPORT
### ON EUROPEAN PATENT APPLICATION NO.

EP 17 38 2908

01-06-2018

| Patent document cited in search report | | Publication date | Patent family member(s) | | Publication date |
|---|---|---|---|---|---|
| US 2013147523 | A1 | 13-06-2013 | NONE | | |
| US 2013009671 | A1 | 10-01-2013 | JP | 5385341 B2 | 08-01-2014 |
| | | | JP | 2013017078 A | 24-01-2013 |
| | | | US | 2013009671 A1 | 10-01-2013 |
| US 2004196678 | A1 | 07-10-2004 | DE | 10356468 A1 | 28-10-2004 |
| | | | JP | 4044861 B2 | 06-02-2008 |
| | | | JP | 2004312817 A | 04-11-2004 |
| | | | US | 2004196678 A1 | 07-10-2004 |
| US 2013155560 | A1 | 20-06-2013 | JP | 5927739 B2 | 01-06-2016 |
| | | | JP | 2013126278 A | 24-06-2013 |
| | | | US | 2013155560 A1 | 20-06-2013 |
| US 2017272068 | A1 | 21-09-2017 | NONE | | |

EPO FORM P0459

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

• US 20160352321 A1